# EUROPEAN PATENT SPECIFICATION

(11) **EP 4 468 371 B1**
(45) Date of publication and mention of the grant of the patent: **31.12.2025**
(21) Application number: 23186040.4
(22) Date of filing: 18.07.2023
(51) Int. Cl.: H10F 19/90, H10F 77/20

(54) **SOLAR CELL, PHOTOVOLTAIC MODULE, AND METHOD FOR PREPARING PHOTOVOLTAIC MODULE**
SOLARZELLE, FOTOVOLTAISCHES MODUL UND VERFAHREN ZUR HERSTELLUNG EINES FOTOVOLTAISCHEN MODULS
CELLULE SOLAIRE, MODULE PHOTOVOLTAÏQUE ET PROCÉDÉ DE PRÉPARATION DE MODULE PHOTOVOLTAÏQUE

(30) Priority: 23.05.2023 CN 202310587109
(43) Date of publication of application: 27.11.2024
(73) Proprietor: JINKO SOLAR CO., LTD., shangrao Jiangxi 334100 (CN); ZHEJIANG JINKO SOLAR CO., LTD., Haining, Zhejiang 314416 (CN)
(72) Inventor: CHEN, Zhendong, Shangrao, 334100 (CN); WANG, Luchuang, Shangrao, 334100 (CN); TAO, Wusong, Shangrao, 334100 (CN); SHI, Jiale, Shangrao, 334100 (CN)
(74) Representative: Balder IP Law, S.L.

(56) References cited:
- WO-A1-2023/280308
- US-A1- 2020 091 351
- US-A1- 2022 077 339

## Description

### TECHNICAL FIELD

Embodiments of the present application relate to the technical field of photovoltaics, and in particular to a solar cell, a photovoltaic module, and a method for preparing a photovoltaic module.

### BACKGROUND

A solar cell is a device that directly convert light energy into electrical energy through photoelectric effect or photochemical effect. A single solar cell cannot be directly used for power generation. Several solar cells must be connected in series, parallel, and tightly encapsulated into components through welding strips before use. A photovoltaic module (i.e., solar cell panel) is the core and most important part of a solar power generation system. The photovoltaic module is configured to convert solar energy into electrical energy, send the electrical energy to an accumulator for storage, or drive a load to operate.

A cell sheet is very fragile, and it is generally necessary to set adhesive films and cover plates on an upper surface and a lower surface of the photovoltaic module to protect the solar cells. The cover plate is generally made of photovoltaic glass, which cannot be directly attached to the solar cell, and the adhesive film needs to play a bonding role in the middle. The connection between the solar cells generally requires a welding strip for collecting current, and conventional welding strips require alloying between the welding strips and fingers during welding. However, the melting point of the solder in the welding strip is generally high, and in the actual welding process, the welding temperature should be higher than the melting point of the solder by more than 20 degrees Celsius. Due to significant warping and deformation during the welding process, there is a high risk of hidden cracks and a high rate of fragmentation after welding. In order to improve welding quality, low-welding temperature welding strips and busbar free technology have emerged. But there are still many factors that affect the yield of the photovoltaic module, such as the welding effect between the welding strips and the fingers, and the welding yield.

D1 (US20200091351A1) discloses a solar cell panel includes a plurality of solar cells including first and second solar cells, and a plurality of wiring members electrically connecting the first and second solar cells. A first electrode of each of the first and second solar cells includes a first bus bar including a plurality of first pad portions. The plurality of first pad portions include a first end pad positioned on one end side of the first bus bar and on which an end of the wiring member is positioned, and a first extension pad positioned on the other end side of the first bus bar and on an extension of the wiring member. An area of the first end pad is different from an area of the first extension pad.

D2 (US20220077339A1) discloses a solar cell according to an embodiment of the present disclosure is positioned so that a second solar cell adjacent to a first solar cell in a first direction have an adjacent portion in contact with or overlapping with the first solar cell in the first direction on a front surface of the first solar cell. In this case, a plurality of wiring members connecting the first and second solar cells are formed to be extended to the front surface of the first solar cell, the adjacent portion, and the rear surface of the second solar cell.

### SUMMARY

The embodiments of the present application provide a solar cell, a photovoltaic module, and a method for preparing the photovoltaic module, which are at least advantageous in improving the yield of the photovoltaic module.

According to a first aspect of the present invention, a solar cell is provided according to claim 1.

In some embodiments, each of the multiple first busbars includes two first electrodes near at least one of the two opposite edges of the substrate along the first direction and multiple second electrodes arranged between the two first electrodes, and each of the two first electrodes includes the at least one first widened portion; each of the multiple second electrodes includes at least one third widened portion arranged opposite to the at least one first widened portion along the first direction, and the at least one third widened portion is smaller than the at least one first widened portion.

In some embodiments, each of the multiple second busbars includes multiple third electrodes arranged at intervals along the first direction and multiple fourth electrodes arranged between every two third electrodes of the multiple third electrodes, and each of the multiple third electrodes includes the at least one second widened portion; each of the multiple fourth electrodes includes at least one fourth widened portion arranged opposite to the at least one second widened portion along the first direction, and the at least one fourth widened portion is smaller than the at least one second widened portion.

In some embodiments, the at least one fourth widened portion is smaller than the at least one first widened portion.

In some embodiments, there are 2 to 20 third electrodes on the second surface.

In some embodiments, the at least one second widened portion has a length of 0.2mm to 1.0mm along the first direction.

In some embodiments, each of the multiple first busbars is integrally formed, and each of the multiple second busbars is integrally formed.

According to a second aspect of the present invention, a photovoltaic module is further provided according to claim 8.

In some embodiments, there are M first overlapping regions between each of the multiple welding strips and the multiple first busbars; there are N adhesive points on each of the multiple welding strips, each of the N adhesive points is configured to cover a respective first overlapping region of the M first overlapping regions at least including a part of the M first overlapping regions defined on at least one the at least one first widened portion, and N is less than M and greater than or equal to a number of the at least one first widened portion; the at least one encapsulation layer is arranged to cover the N adhesive points.

In some embodiments, N is less than or equal to the number of the at least one second widened portion.

In some embodiments, 2 ≤ N ≤ 20.

In some embodiments, the at least one encapsulation layer is arranged on a surface of each of the multiple second busbars, a part of the multiple welding strips arranged on the second surface is in direct contact with the at least one encapsulation layer, and there is no adhesive point on the second surface.

According to a third aspect of the present invention, a method for preparing a photovoltaic module is further provided according to claim 12.

In some embodiments, there are M first overlapping regions between each of the multiple welding strips and the multiple first busbars. After the welding treatment, the method further includes: dispensing adhesive on a part of first overlapping regions on each of the multiple solar cells to form N adhesive points on the first surface of the substrate, where each of the N adhesive points is configured to cover a respective first overlapping region of the M first overlapping regions at least including a part of the M first overlapping regions defined on at least one the at least one first widened portion, and N is less than M and greater than or equal to a number of the at least one first widened portion.

### BRIEF DESCRIPTION OF THE DRAWINGS

One or more embodiments are described as examples with reference to the corresponding figures in the accompanying drawings, and the exemplary description does not constitute a limitation to the embodiments. The figures in the accompanying drawings do not constitute a proportion limitation unless otherwise stated. For more clearly illustrating embodiments of the present disclosure or the technical solutions in the conventional technology, drawings referred to for describing the embodiments or the conventional technology will be briefly described hereinafter. Apparently, drawings in the following description are only examples of the present disclosure, and for the person skilled in the art, other drawings may be acquired based on the provided drawings without any creative efforts.
FIG. 1 is a first schematic structural view of a first surface of a solar cell provided according to an embodiment of the present application;
FIG. 2 is a first cross-sectional view of the solar cell shown in FIG. 1 along A1-A2;
FIG. 3 is a second cross-sectional view of a solar cell according to an example useful for understanding the present invention but not covered by the scope of the claims.
FIG. 4 is a first cross-sectional view of the solar cell shown in FIG. 1 along B1-B2;
FIG. 5 is a local schematic structural view of a first widened portion of a solar cell provided according to an embodiment of the present application;
FIG. 6 is a first schematic structural view of a second surface of a solar cell provided according to an embodiment of the present application;
FIG. 7 is a local schematic structural view of a second widened portion of a solar cell provided according to an embodiment of the present application;
FIG. 8 is a second schematic structural view of a first surface of a solar cell provided according to an embodiment of the present application;
FIG. 9 is a local schematic structural view of a third widened portion of a solar cell provided according to an embodiment of the present application;
FIG. 10 is a second schematic structural view of a second surface of a solar cell provided according to an embodiment of the present application;
FIG. 11 is a local schematic structural view of a fourth widened portion of a solar cell provided according to an embodiment of the present application;
FIG. 12 is a third schematic structural view of a first surface of a solar cell provided according to an embodiment of the present application;
FIG. 13 is a schematic structural view of welding strips formed on a first surface of a solar cell provided according to an embodiment of the present application;
FIG. 14 is a schematic structural view of welding strips formed on a second surface of a solar cell provided according to an embodiment of the present application;
FIG. 15 is a schematic structural view of adhesive points formed on a first surface of a solar cell provided according to an embodiment of the present application; and
FIG. 16 is a schematic structural view of a photovoltaic module provided according to an embodiment of the present application.

### DETAILED DESCRIPTION

It can be seen from the background technology that the yield of photovoltaic modules is currently poor.

In the solar cell provided according to the embodiments of the present application, the substrate has the first surface and the second surface opposite to the first surface, each of the multiple first busbars arranged on the first surface has a first widened portion, and each of the multiple second busbars arranged on the second surface has a second widened portion. The at least one first widened portion and the at least one second widened portion can increase the welding tension between the multiple first busbars and the multiple welding strips, as well as the welding tension between the multiple second busbars and the multiple welding strips, thus improving the welding effect between the multiple first busbars and the multiple welding strips, as well as the welding effect between the multiple second busbars and the multiple welding strips. The at least one first widened portion is larger than the at least one second widened portion. By setting the size of the at least one first widened portion on the first surface and the size of the at least one second widened portion on the second surface, it is ensured that the size of the at least one first widened portion on the first surface is smaller, resulting in a smaller covering area on the first surface and improving the efficiency of the solar cell. The at least one second widened portion of the second surface is at least near at least one of the two opposite edges of the substrate, that is, the number of the at least one second widened portions is greater than or equal to the number of the at least one first widened portions, thereby increasing the welding area of the second surface by increasing the number of the at least one second widened portions, thereby improving the welding tension between the solar cell and the multiple welding strips.

The embodiments of the present application will be described in detail below with reference to the accompanying drawings. However, those of ordinary skill in the art can understand that, in various embodiment of the present application, many technical details are set forth in order to provide the reader with a better understanding of the present application. However, the technical solutions claimed in the present application may be realized even without these technical details and various changes and modifications based on the following embodiments.

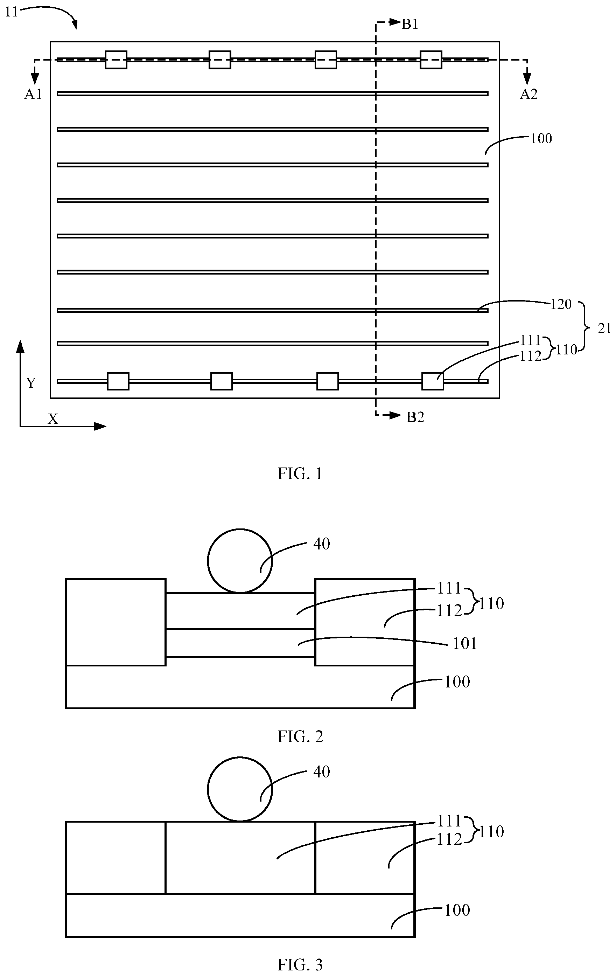

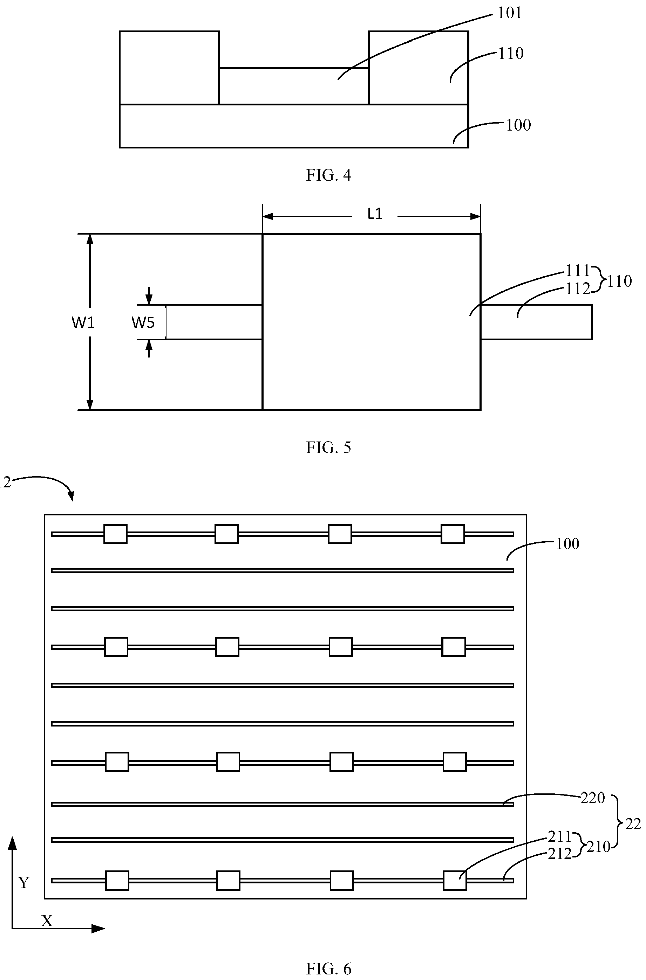

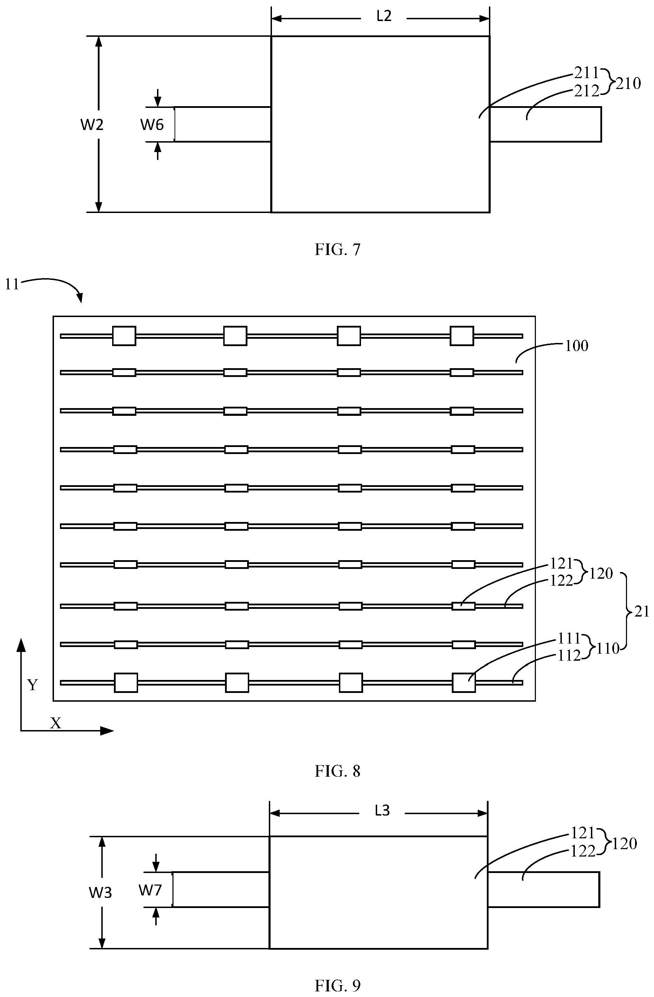

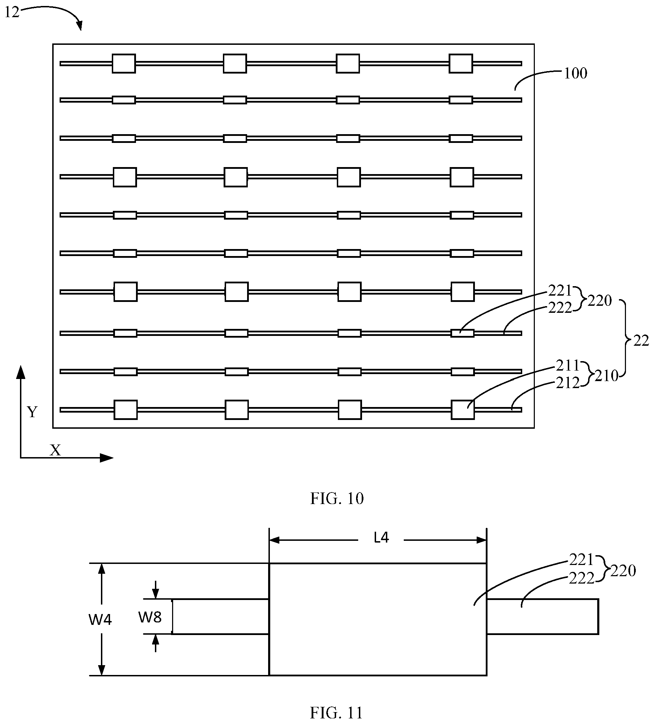

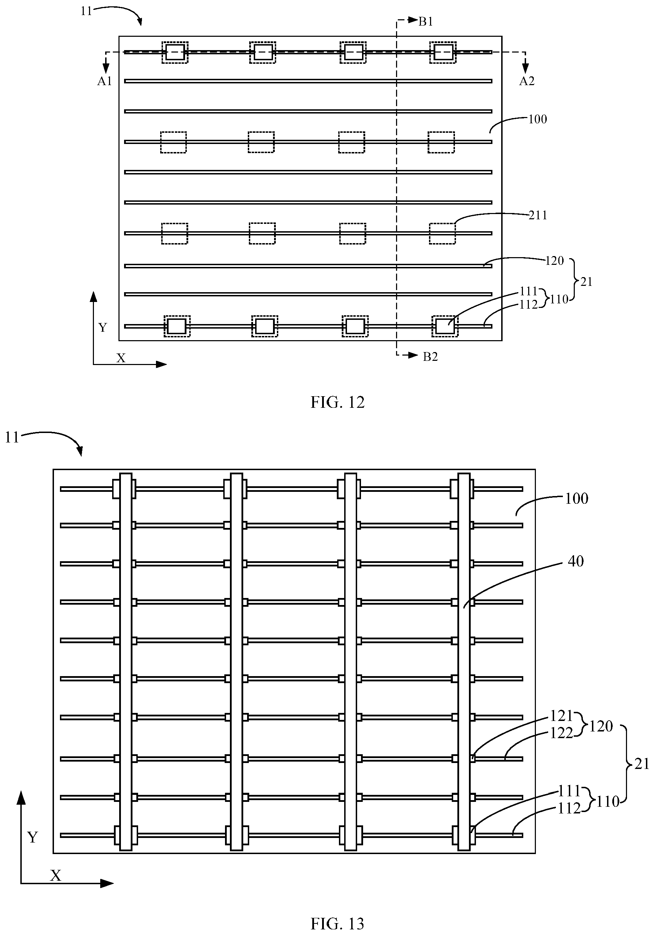

FIG. 1 is a first schematic structural view of a first surface of a solar cell provided according to an embodiment of the present application. FIG. 2 is a first cross-sectional view of the solar cell shown in FIG. 1 along A1-A2. FIG. 3 is a second cross-sectional view of the solar cell shown in FIG. 1 along A1-A2. FIG. 4 is a first cross-sectional view of the solar cell shown in FIG. 1 along B 1-B2. FIG. 5 is a local schematic structural view of a first widened portion of a solar cell provided according to an embodiment of the present application. FIG. 6 is a first schematic structural view of a second surface of a solar cell provided according to an embodiment of the present application. FIG. 7 is a local schematic structural view of a second widened portion of a solar cell provided according to an embodiment of the present application. FIG. 8 is a second schematic structural view of a first surface of a solar cell provided according to an embodiment of the present application. FIG. 9 is a local schematic structural view of a third widened portion of a solar cell provided according to an embodiment of the present application. FIG. 10 is a second schematic structural view of a second surface of a solar cell provided according to an embodiment of the present application. FIG. 11 is a local schematic structural view of a fourth widened portion of a solar cell provided according to an embodiment of the present application. FIG. 12 is a third schematic structural view of a first surface of a solar cell provided according to an embodiment of the present application. In order to illustrate the relative position relationship between the at least one first widened portion and the welding strip, the welding strip is also illustrated in FIG. 2 and FIG. 3. In order to illustrate the at least one first widened portion and the at least one second widened portion, the at least one second widened portion is shown in FIG. 12 as regions enclosed by dashed lines.

It can be understood that the cross-sectional view between the at least one second widened portion of the second surface and the second busbar may refer to the positional relationship between the at least one first widened portion and the first busbars in FIG. 2 to FIG. 4. The cross-sectional view of the second surface is not shown here, the cross-sectional view on the side of the first surface is shown.

Referring to FIG. 1 to FIG. 12, according to some embodiments of the present application, in the first aspect, a solar cell is provided according to the present application, and the solar cell includes a substrate 100 having a first surface 11 and a second surface 12 opposite to the first surface 11, and multiple first busbars 21 arranged at intervals on the first surface 11 of the substrate 100, and each of the multiple first busbars 21 extends along a first direction Y. At least one of the multiple first busbars 21 near at least one of two opposite edges of the substrate 100 along the first direction Y includes at least one first widened portion 11. The solar cell further includes multiple second busbars 22 arranged at intervals on the second surface 12 of the substrate 100, and each of the multiple second busbars extends along the first direction Y. At least one of the multiple second busbars 22 near at least one of the two opposite edges of the substrate 100 along the first direction Y includes at least one second widened portion 211, and the at least one second widened portion 211 is larger than each of the at least one first widened portion 111.

The solar cell may be any of a conventional tunnel oxide passivated contact (TOPCON) cell, a passivated emitter and real cell (PERC) cell, and a heterojunction cell. In some embodiments, the solar cell may also be a compound cell, and the compound includes but is not limited to silicon germanide, silicon carbide, gallium arsenide, indium gallide, perovskite, cadmium telluride, copper indium diselenide and other materials.

The solar cell includes a substrate that is sequentially stacked and a passivation layer. The material of the substrate 100 may be an elemental semiconductor material. Specifically, the elemental semiconductor material is composed of a single element, such as silicon. Among them, the element semiconductor material may be in a single crystal state, a polycrystalline state, an amorphous state, or a microcrystalline state (with both single crystal and amorphous states, referred to as microcrystalline state), for example, silicon can be at least one of monocrystalline silicon, polycrystalline silicon, amorphous silicon, or microcrystalline silicon.

In some embodiments, the material of the substrate 100 may also be a compound semiconductor material. Common compound semiconductor materials include but are not limited to silicon germanide, silicon carbide, gallium arsenide, indium gallide, perovskite, cadmium telluride, copper indium diselenide. The substrate 100 may also be a sapphire substrate, a silicon substrate on an insulator, or a germanium substrate on an insulator.

In some embodiments, the substrate 100 may be an N-type semiconductor substrate or a P-type semiconductor substrate. The N-type semiconductor substrate is doped with N-type doping elements, which can be any of the V group elements such as phosphorus (P), bismuth (Bi), antimony (Sb), or arsenic (As). The P-type semiconductor substrate is doped with P-type elements, which can be any of the III group elements such as boron (B), aluminum (Al), gallium (Ga), or gallium (In).

In some embodiments, the solar cell further includes a passivation layer 101, which is arranged on the first surface of the substrate 100. The materials of the passivation layer 101 include any one or more of materials such as silicon oxide, silicon nitride, silicon nitride, carbon nitrogen oxide, titanium oxide, hafnium oxide, or aluminum oxide.

The solar cell includes an emitter and a first passivation layer arranged on the first surface 11 of the substrate 100, a second passivation layer arranged on the second surface 12 of the substrate 100. Each of the multiple first busbar 21 penetrates through the first passivation layer to be in electrical contact with the emitter, and each of the multiple second busbars 22 penetrates through the second passivation layer to be in electrical contact with the second surface 12. The passivation layer 101 includes a first passivation layer and a second passivation layer.

In some embodiments, in response to the solar cell being a TOPCON cell, the solar cell further includes a tunneling dielectric layer and a doped conductive layer stacked together. The tunneling dielectric layer is arranged on the second surface 12 of the substrate 100, and the multiple second busbars 22 penetrate through the second passivation layer to be in electrical contact with the doped conductive layer.

In some embodiments, the multiple first busbars 21 and the multiple second busbars 22 are fingers of the solar cell, and the fingers can be sintered from the burn-through slurry. The multiple first busbars 21 and the multiple second busbars 22 are formed by a screen-printing process to print metal slurry on the surface of a part of the passivation layer. Metal slurry includes at least one of silver, copper, tin, gold, lead, or nickel. The sintering process is carried out on the metal slurry. In some embodiments, the metal slurry contains materials with high corrosive components such as glass. Therefore, during the sintering process, the corrosive components will corrode the passivation layer, which causes the metal slurry to penetrate into the passivation layer 101 to be in electrical contact with the substrate 100.

In some embodiments, each of the multiple first busbars 21 includes two first electrodes 110 near at least one of the two opposite edges of the substrate 100 along the first direction Y and multiple second electrodes 120 arranged between the two first electrodes 110. Each of the two first electrodes 110 includes a first widened portion 111, and two first fingers 112 arranged on two sides of the at least one first widened portion 111, respectively. Each of the two first fingers 112 penetrates through the passivation layer 101 and protrudes from the passivation layer 101.

In some embodiments, referring to FIG. 2, the at least one first widened portion 111 is arranged on the surface of the passivation layer 101 away from the substrate and does not penetrate through the passivation layer 101, so that the material composition of the at least one first widened portion 111 is not the same as that of the first finger 112. For example, the at least one first widened portion 111 is prepared from the printing slurry of busbars, and the two first fingers 112 are prepared from the printing slurry of fingers. Among them, the silver content in the printing slurry of the fingers is relatively high, which leads to the burning through of the passivation layer. The silver content in the printing slurry of the busbars is lower, while the aluminum content is higher.

In some embodiments, the at least one first widened portion 111 has a first length L1 of 0.5mm to 1.5mm along the second direction X. The first length L1 may be from 0.5mm to 0.8mm, 0.58mm to 1.39mm, 0.6mm to 1.5mm, 0.9mm to 1.48mm, 0.5mm to 1mm, 0.6mm to 1.3mm, or 0.69mm to 0.8mm. The first length L1 may be 0.53mm, 0.58mm, 0.77mm, 0.98mm, 1.19mm, 1.28mm, 1.33mm, 1.42mm, or 1.5mm.

In some embodiments, the at least one first widened portion 111 has a first length W1 of 0.1mm to 0.5mm along the first direction Y. The first width W1 may be from 0.1mm to 0.16mm, 0.16mm to 0.28mm, 0.28mm to 0.41mm, 0.41mm to 0.5mm, 0.14mm to 0.45mm, 0.16mm to 0.28mm, or 0.19mm to 0.036mm. The first width W1 may be 0.12mm, 0.18mm, 0.21mm, 0.33mm, 0.35mm, 0.42mm, 0.46mm, or 0.5mm.

In some embodiments, the first finger 102 has a fifth width W5 of 10 µm to 45 µm along the first direction Y. The fifth width W5 may be from 11µm to 15µm, 15µm to 20µm, 20µm to 38µm, 38µm to 45µm, 10µm to 25µm, 18µm to 32µm, or 14µm to 37µm. The fifth width W5 may be 10.3µm, 16.8µm, 21.7µm, 33.6µm, 35.8µm, 41.1µm, 42.3µm, or 45µm.

In some embodiments, referring to FIG. 3, the first busbar 21 is integrally formed, that is, the at least one first widened portion 111 and the first finger 112 of the first electrode 110 are also integrally formed. The at least one first widened portion 111 and the first finger 112 can be prepared by the same printing slurry in the same preparation process, and both the at least one first widened portion 111 and the first finger 112 penetrates through the passivation layer 101. In this way, the width of the first busbar 21 near at least one of the two opposite edges of the solar cell is relatively large, which can alleviate the welding stress of the first electrode 110 and form good contact between the welding strip 40 and the solar cell. In addition, the at least one first widened portion 111 can enhance the carrier transmission capacity, thereby allowing the solar cell to have a larger transmission area for collecting current.

In some embodiments, each of the multiple second busbars 22 includes multiple third electrodes 210 arranged at intervals along the first direction Y and multiple fourth electrodes 220 arranged between every two third electrodes 210 of the multiple third electrodes 210. Each of the multiple third electrodes 210 includes the at least one second widened portion 211, and two second fingers 212 arranged at two sides of the at least one second widened portion 211, respectively. Each of the two second fingers 212 penetrates through the passivation layer 101 and protrudes from the passivation layer 101.

In some embodiments, the number of third electrodes 210 within the second surface 12 is 2 to 20. The number of the third electrode 210 is the number of the at least one second widened portion 211, which is greater than or equal to the number of the at least one first widened portion 111. In this way, the shielding area of the first surface 11 can be reduced, thereby improving the efficiency of the solar cell. By increasing the number of the at least one second widened portion 211 to increase the welding area of the second surface, thereby improving the welding tension between the solar cell and the welding strip.

In some embodiments, the at least one second widened portion 211 has a second width W2 of 0.2mm to 1.0mm along the first direction Y. The second width W2 may be from 0.21mm to 0.8mm, 0.2mm to 0.8mm, 0.38mm to 0.78mm, 0.25mm to 0.94mm, 0.29mm to 0.99mm, 0.5mm to 0.82mm, 0.86mm to 1.0mm, or 0.19mm to 0.69mm. The second width W2 may be 0.21mm, 0.38mm, 0.41mm, 0.53mm, 0.65mm, 0.78mm, 0.89mm, or 0.98mm.

In some embodiments, the at least one second widened portion 211 has a second length L2 of 0.5mm to 1.5mm along the second direction X. The second length L2 may be from 0.5mm to 0.8mm, 0.54mm to 1.39mm, 0.6mm to 1.5mm, 0.9mm to 1.48mm, 0.5mm to 1mm, 0.6mm to 1.3mm, or 0.56mm to 0.8mm. The second length L2 may be 0.53mm, 0.58mm, 0.77mm, 0.98mm, 1.19mm, 1.28mm, 1.33mm, 1.42mm, or 1.5mm.

In some embodiments, the at least one second widened portion 211 is arranged on the surface of the passivation layer 101 and does not penetrate through the passivation layer 101, so that the material composition of the at least one second widened portion 211 is not the same as that of the second finger 212. For example, the at least one second widened portion 211 is prepared from the printing slurry of the busbar, and the second finger 212 is prepared from the printing slurry of the finger.

In some embodiments, the second busbar 22 is integrally formed, that is, the at least one second widened portion 211 and the second finger 212 of the third electrode 210 are also integrally formed. The at least one second widened portion 211 and the second finger 212 can be prepared by the same printing slurry in the same preparation process, and both the at least one second widened portion 211 and the second finger 212 penetrate through the passivation layer 101. In this way, the width of the second busbar 22 near at least one of the two opposite edges of the solar cell is relatively large, which can alleviate the welding stress of the third electrode 210 and form good contact between the welding strip and the solar cell. In addition, the at least one second widened portion 211 can enhance the carrier transmission capacity, thereby allowing the solar cell to have a larger transmission area for collecting current.

In some embodiments, the second finger 212 has a sixth width W6 of 14 µm to 60 µm. The sixth width W6 may be from 15µm to 20µm, 20µm to 28µm, 28µm to 35µm, 35µm to 49µm, 49µm to 52µm, 52µm to 60µm, or 18µm to 39µm. The sixth width W6 may be 14.3µm, 24.8µm, 35.7µm, 41.8µm, 47.8µm, 52.1µm, 59.6µm, or 60µm.

Referring to FIG. 8, the second electrode 120 includes at least one third widened portion 121, which is opposite to the at least one third widened portion 121 in the first direction Y. The at least one third widened portion 121 is smaller than the at least one first widened portion 111. The second electrode 120 further includes two third finger 122 arranged on two sides of the at least one third widened portion 121, respectively. The third finger 122 penetrates through the passivation layer 101 and protrudes from the passivation layer 101.

In some embodiments, the at least one third widened portion 121 is arranged on the surface of the passivation layer 101 and does not penetrate through the passivation layer 101, so that the material composition of the at least one third widened portion 121 is not the same as that of the third finger 122. For example, the at least one third widened portion 121 is prepared from the printing slurry of the busbar, and the third finger 122 is prepared from the printing slurry of the finger.

In some embodiments, referring to FIG. 9, the at least one third widened portion 121 has a third length L3 of 0.5mm to 1.5mm along the second direction X. The third length L3 may be from 0.5mm to 0.8mm, 0.58mm to 1.39mm, 0.6mm to 1.5mm, 0.9mm to 1.48mm, 0.5mm to 1mm, 0.6mm to 1.3mm, or 0.69mm to 0.8mm. The third length L3 may be 0.53mm, 0.58mm, 0.77mm, 0.98mm, 1.19mm, 1.28mm, 1.33mm, 1.42mm, or 1.5mm.

In some embodiments, the at least one third widened portion 121 has a third width W3 of 0.02mm to 0.2mm along the first direction Y. The third width W3 may be from 0.02mm to 0.1mm, 0.18mm to 0.18mm, 0.2mm to 0.14mm, 0.09mm to 0.19mm, 0.05mm to 0.12mm, 0.16mm to 0.2mm, or 0.09mm to 0.19mm. The third width W3 may be 0.02mm, 0.08mm, 0.11mm, 0.13mm, 0.15mm, 0.18mm, 0.19mm, or 0.2mm.

In some embodiments, the third finger 122 has a seventh width W7 of 10µm to 45µm along the first direction Y. The seventh width W7 may be from 11µm to 15µm, 15µm to 20µm, 20µm to 38µm, 38µm to 45µm, 10µm to 25µm, 18µm to 32µm, or 14µm to 37µm. The seventh width W7 may be 10.3µm, 16.8µm, 21.7µm, 33.6µm, 35.8µm, 41.1µm, 42.3µm, or 45µm.

In some embodiments, the first busbar 21 is integrally formed, that is, the at least one third widened portion 121 and the third finger 122 of the third electrode 120 are also integrally formed. The at least one third widened portion 121 and the third finger 122 can be prepared by the same printing slurry in the same preparation process, and both the at least one third widened portion 121 and the third finger 122 penetrate through the passivation layer 101. The at least one third widened portion 121 and the third busbar 122 can enhance the carrier transmission capacity, thereby allowing the solar cell to have a larger transmission area for collecting current.

In some embodiments, referring to FIG. 10, the fourth electrode 220 includes at least one fourth widened portion 221, which is opposite to the at least one second widened portion 211 along the first direction Y. The at least one fourth widened portion 221 is smaller than the at least one second widened portion 211.

In some embodiments, the at least one fourth widened portion 221 is smaller than the at least one first widened portion 111. The fourth electrode 220 further includes two second finger 212 arranged on two sides of the at least one fourth widened portion 221, respectively. The second finger 212 penetrates through the passivation layer 101 and protrudes from the passivation layer 101.

In some embodiments, the at least one fourth widened portion 221 has a fourth width W4 of 0.02mm to 0.2mm along the first direction Y. The fourth width W4 may be from 0.02mm to 0.1mm, 0.18mm to 0.18mm, 0.2mm to 0.14mm, 0.09mm to 0.19mm, 0.05mm to 0.12mm, 0.16mm to 0.2mm, or 0.09mm to 0.19mm. The fourth width W4 may be 0.02mm, 0.08mm, 0.11mm, 0.13mm, 0.15mm, 0.18mm, 0.19mm, or 0.2mm.

In some embodiments, the at least one fourth widened portion 221 has a fourth length L4 of 0.5mm to 1.5mm along the second direction X. The fourth length L4 may be from 0.5mm to 0.8mm, 0.54mm to 1.39mm, 0.6mm to 1.5mm, 0.9mm to 1.48mm, 0.5mm to 1mm, 0.6mm to 1.3mm, or 0.56mm to 0.8mm. The fourth length L4 may be 0.53mm, 0.58mm, 0.77mm, 0.98mm, 1.19mm, 1.28mm, 1.33mm, 1.42mm, or 1.5mm.

In some embodiments, the at least one fourth widened portion 221 is arranged on the surface of the passivation layer 101 and does not penetrate through the passivation layer 101, so that that the material composition of the at least one fourth widened portion 221 is not the same as that of the fourth finger 222. For example, the at least one fourth widened portion 221 is prepared from the printing slurry of the busbar, and the fourth finger is prepared from the printing slurry of the finger.

In some embodiments, the second busbar 22 is integrally formed, that is, the at least one fourth widened portion 221 and the fourth finger 222 of the fourth electrode 220 are also integrally formed. The at least one fourth widened portion 221 and the fourth finger 222 can be prepared by the same printing slurry in the same preparation process, and both the at least one fourth widened portion 221 and the fourth finger 222 penetrate through the passivation layer 101. In this way, the width of the second busbar 22 near at least one of the two opposite edges of the solar cell is relatively large, which can alleviate the welding stress of the third electrode 220 and form good contact between the welding strip and the solar cell. In addition, the at least one fourth widened portion 221 can enhance the carrier transmission capacity, allowing the solar cell to have a larger transmission area for collecting current.

In some embodiments, the solar cell is a sliced cell. In some embodiments, the sliced cell is a half-cell, and the half-cell may also be understood as a cell cut in half or a 1/2 cell. In other embodiments, the sliced cell may be a 1/3 cell, a 1/4 cell, or a 1/8 cell, etc.

Embodiment 0: the at least one first widened portion and second widened portion are not provided, that is, each busbar is a complete and uniform busbar.

Embodiment 1: the number of the at least one first widened portions is equal to the number of the at least one second widened portions, and there is no adhesive point on the first surface. The at least one second widened portion is larger than the at least one first widened portion. The first width W1 of the at least one first widened portion is 0.3mm, the first length L1 of the at least one first widened portion is 0.8mm, the second width W2 of the at least one second widened portion is 0.3mm, and the second length L2 of the at least one second widened portion is 1.0mm. The number of first widened portions is 2, and the number of second widened portions is 2.

Embodiment 2: the number of first widened portions is smaller than the number of second widened portions, there are no adhesive points on the first surface, and the at least one second widened portion is larger than the at least one first widened portion. The first width W1 of the at least one first widened portion is 0.3mm, the first length L1 of the at least one first widened portion is 0.8mm, the second width W2 of the at least one second widened portion is 0.3mm, and the second length L2 of the at least one second widened portion is 1.0mm. The number of first widened portions is 2, and the number of second widened portions is 4.

Embodiment 3: the number of the at least one first widened portion is smaller than the number of the at least one second widened portion, there are adhesive points on the first surface, and the at least one second widened portion is larger than the at least one first widened portion. The first width W1 of the at least one first widened portion is 0.3mm, the first length L1 of the at least one first widened portion is 0.8mm, the second width W2 of the at least one second widened portion is 0.3mm, and the second length L2 of the at least one second widened portion is 1.0mm. The number of adhesive points is 4, the number of the at least one first widened portion is 2, and the number of second widened portions is 4.

Embodiment 4: the number of first widened portions is equal to the number of second widened portions. The first surface has adhesive points, and the at least one second widened portion is larger than the at least one first widened portion. The first width W1 of the at least one first widened portion is 0.3mm, the first length L1 of the at least one first widened portion is 0.8mm, the second width W2 of the at least one second widened portion is 0.3mm, and the second length L2 of the at least one second widened portion is 1.0mm. The number of first widened portions is 2, the number of second widened portions is 2, and the number of adhesive points is 4. The first surface has the at least one third widened portions, and the second surface have the at least one fourth widened portions.

**Table 1**

| Embodiments | Ratio of welding tension between welding strips and solar cell on the first surface and welding tension between welding strips and solar cell in Embodiment 0 | Ratio of welding tension between welding strips and solar cell on the second surface and welding tension between welding strips and solar cell in Embodiment 0 | Ratio of yield | Ratio of costs |
|---|---|---|---|---|
| Embodiment 0 | 1 | 1 | 1 | 1 |
| Embodiment 1 | 103% | 105% | 103% | 108% |
| Embodiment 2 | 103% | 110% | 108% | 112% |
| Embodiment 3 | 115% | 110% | 118% | 118% |
| Embodiment 4 | 115% | 115% | 131% | 123% |

According to Table 1, the number and size of the at least one second widened portions are set to increase the welding tension between the welding strip and the solar cell. Among them, the ratio of welding tension between each embodiment and embodiment 0 can indicate that in response to adhesive points being arranged between the welding strip and the solar cell on the first surface, the welding tension is better.

In the solar cell provided according to the embodiments of the present application, the substrate has the first surface and the second surface opposite to the first surface, each of the multiple first busbars arranged on the first surface has a first widened portion, and each of the multiple second busbars arranged on the second surface has a second widened portion. The at least one first widened portion and the at least one second widened portion can increase the welding tension between the multiple first busbars and the multiple welding strips, as well as the welding tension between the multiple second busbars and the multiple welding strips, thus improving the welding effect between the multiple first busbars and the multiple welding strips, as well as the welding effect between the multiple second busbars and the multiple welding strips. The at least one first widened portion is larger than the at least one second widened portion. By setting the size of the at least one first widened portion on the first surface and the size of the at least one second widened portion on the second surface, it is ensured that the size of the at least one first widened portion on the first surface is smaller, resulting in a smaller covering area on the first surface and improving the efficiency of the solar cell. The at least one second widened portion of the second surface is at least near at least one of the two opposite edges of the substrate, that is, the number of the at least one second widened portions is greater than or equal to the number of the at least one first widened portions, thereby increasing the welding area of the second surface by increasing the number of the at least one second widened portions, thereby improving the welding tension between the solar cell and the multiple welding strips.

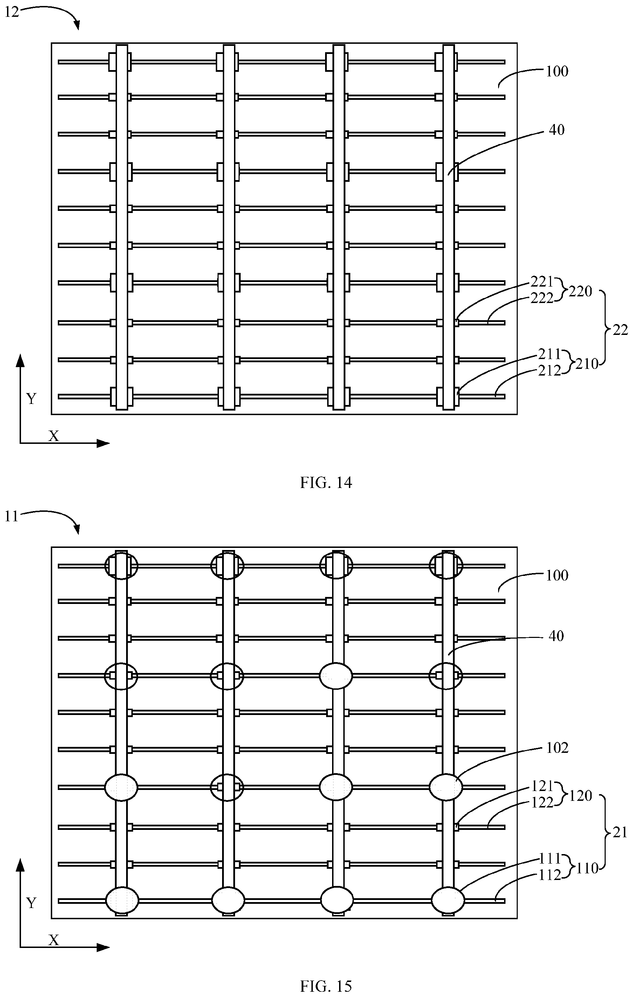

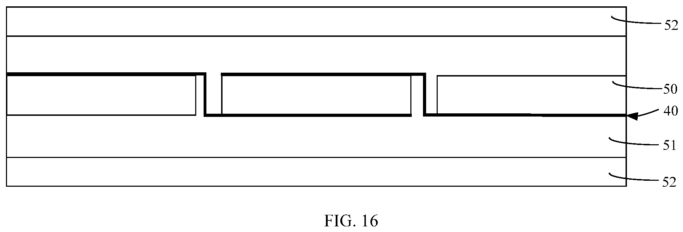

FIG. 13 is a schematic structural view of welding strips formed on a first surface of a solar cell provided according to an embodiment of the present application. FIG. 14 is a schematic structural view of welding strips formed on a second surface of a solar cell provided according to an embodiment of the present application. FIG. 15 is a schematic structural view of adhesive points formed on a first surface of a solar cell provided according to an embodiment of the present application. FIG. 16 is a schematic structural view of a photovoltaic module provided according to an embodiment of the present application.

According to some embodiments of the present application, in a second aspect, a photovoltaic module is further provided according to the present application, the photovoltaic module includes: at least one cell string, where the cell string is formed by electrically connecting multiple solar cells 50 with each other by multiple welding strips 40. Each of the multiple welding strips 40 is electrically connected to a respective first busbar 21 in the multiple first busbars 21 and/or a respective second busbar 22 in the multiple second busbars 22, and any of the multiple welding strips 40 is in electrical contact with at least one first widened portion 111 or at least one second widened portion 211. The photovoltaic module further includes at least one encapsulation layer 51 configured to cover the at least one cell string and at least one cover plate 52 is configured to cover the at least one encapsulation layer 51.

Specifically, in some embodiments, multiple cell strings 40 can be electrically connected through multiple welding strips 40. FIG. 16 only illustrates the positional relationship between solar cells 50, that is, the electrodes of solar cells 50 with the same polarity are arranged in the same direction or have positive polarity for each cell, and are arranged towards the same side, so that the welding strips are connected to different sides of two adjacent cells. In some embodiments, the solar cell 50 can also be arranged in the order of electrodes with different polarities facing the same side, that is, the electrodes of adjacent multiple solar cells are sorted in order of first polarity, second polarity. The multiple solar cells with first polarity are arranged in order, so that the welding strips are connected to two adjacent solar cells on the same side.

In some embodiments, there is no interval set between the solar cells 50, that is, the solar cells 50 overlap with each other.

In some embodiments, the cross-sectional shape of the welding strip 40 may be circular as shown in FIG. 11. The circular welding strip does not have orientation or alignment issues, which makes it easier to mass produce. In some embodiments, the cross-sectional shape of the welding strip 40 may be triangular or any other shape to increase the contact area between the welding strip and reinforcing gate lines and reduce the alignment deviation between the welding strip 40 and the reinforcing gate lines.

In some embodiments, the welding strip 40 has a width of 160µm to 300µm, and the number of welding strips is 12 to 30 per solar cell. The width of the welding strip 40 may be from 160µm to 180µm, 180µm to 200µm, 200µm to 220µm, 220µm to 240µm, 240µm to 280µm, and 280µm to 300µm.

In some embodiments, there are M first overlapping regions between each of the multiple welding strips 40 and the multiple first busbars 21. There are N adhesive points 102 on each of the multiple welding strips 40, each of the N adhesive points 102 is configured to cover a respective first overlapping region of the M first overlapping regions at least including a part of the M first overlapping regions defined on at least one the at least one first widened portion 21, and N is less than M and greater than or equal to a number of the at least one first widened portion 21. The at least one encapsulation layer is arranged to cover the N adhesive points. In this way, the welding strip 40 is accurately positioned through the adhesive points 102, and the positional relationship between the welding strip 40 and the first busbar 21 is accurately arranged. Subsequent welding or lamination treatment ensures good contact between the welding strip 40 and the solar cell, which improves welding tension, and maximizes the efficiency of the solar cell.

In some embodiments, each of the N adhesive points 102 is configured to completely cover the first overlapping region, and the area of each of the N adhesive points 102 is greater than or equal to 1.5 times the area of each of the M first overlapping region, thereby firmly positioning the welding strip on the surface of the solar cell and improving the welding tension between the solar cell and the welding strip. The adhesive point can also prevent problems such as deviation of the welding strip during subsequent lamination processing.

In some embodiments, N is less than or equal to the number of second widened portions 211, or 2 ≤ N ≤ 20.

In some embodiments, the at least one encapsulation layer 51 is arranged on a surface of each of the multiple second busbars 22, a part of the multiple welding strips 40 arranged on the second surface 12 is in direct contact with the at least one encapsulation layer 51, and there is no adhesive point on the second surface 12. By not setting adhesive points on the second surface 12, the number and size of the at least one second widened portion are increased to increase the welding tension between the solar cell and the welding strip. In this way, the operation of dispensing adhesive can be avoided, thereby reducing the process difficulty.

In some embodiments, the encapsulation layer 51 includes a first encapsulation layer and a second encapsulation layer. The first encapsulation layer is configured to cover one of the front surface or the rear surface of the solar cell 50, and the second encapsulation layer is configured to cover the other of the front surface or the rear surface of the solar cell 50. Specifically, at least one of the first encapsulation layer or the second encapsulation layer is an organic encapsulation film such as a polyvinyl butyral (PVB) adhesive film, an ethylene vinyl acetate copolymer (EVA) film, a polyethylene octene co-elastomer (POE) film, or a polyethylene terephthalate (PET) film, or at least one of the first encapsulation layer or the second encapsulation layer may also be a co-extruded film of one layer of EVA, one layer of POE, and one layer of EVA (EPE) or a co-extruded film of one layer of EVA and one layer of POE (EP).

It can be understood that there is a boundary between the first encapsulation layer and the second encapsulation layer before lamination, and the concept of the first encapsulation layer and the second encapsulation layer will no longer exist when forming the photovoltaic modules after lamination. The first encapsulation layer and the second encapsulation layer have already integrally formed the encapsulation layer 51.

In some embodiments, the cover plate 52 may be a glass cover plate, a plastic cover plate, or other cover plates with light transmission function. Specifically, the surface of the cover plate 52 towards the encapsulation layer 51 can be a surface with protrusions and recesses, thereby increasing the utilization of incident light. The cover plate 52 includes a first cover plate and a second cover plate. The first cover plate faces towards the first encapsulation layer, and the second cover plate faces towards the second encapsulation layer.

According to some embodiments of the present application, in a third aspect, a method for preparing a photovoltaic module is further provided according to the present application, the method includes providing multiple solar cells and multiple welding strips, welding each of the multiple welding strips and a corresponding solar cell of the multiple solar cells together to form an alloy layer between each of the multiple welding strips and each of multiple first busbars, and between each of the multiple welding strips and each of multiple second busbars, where the multiple solar cells form at least one cell string by the multiple welding strips after welding treatment. The method further includes providing at least one encapsulation layer and at least one cover plate, where the at least one encapsulation layer is configured to cover the at least one cell string, and the at least one cover plate is configured to cover the at least one encapsulation layer. The method further includes laminating the at least one cell string, the at least one encapsulation layer, and the at least one cover plate.

In some embodiments, there are M first overlapping regions between each of the multiple welding strips and the multiple first busbars. After the welding treatment, the method further includes: dispensing adhesive on a part of first overlapping regions on each of the multiple solar cells to form N adhesive points on the first surface of the substrate, where each of the N adhesive points is configured to cover a respective first overlapping region of the M first overlapping regions at least including a part of the M first overlapping regions defined on at least one the at least one first widened portion, and N is less than M and greater than or equal to a number of the at least one first widened portion.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

Although the present application is disclosed above with preferred embodiments, it is not used to limit the claims. The scope of protection shall be subject to the scope defined by the claims of the present application. In addition, the embodiments and the accompanying drawings in the specification of the present application are only illustrative examples, which will not limit the scope protected by the claims of the present application.

Those of ordinary skill in the art can understand that the above embodiments are specific examples for realizing the present application, and in actual disclosures, various changes may be made in shape and details without departing from the present application as defined by the scope of the claims. Therefore, the protection scope of the present application should be subject to the scope defined by the claims.

## Claims

1. A solar cell, comprising:
a substrate (100) having a first surface (11) and a second surface (12) opposite to the first surface (11);
a plurality of first busbars (21) arranged at intervals on the first surface (11) of the substrate (100) along a first direction (Y), each of the plurality of first busbars (21) extending along a second direction (X), wherein each of at least one of the plurality of first busbars (21) adjacent to at least one of two opposite edges of the substrate (100) extending along the second direction (X) comprises at least one first widened portion (111) and first fingers (112); and
a plurality of second busbars (22) arranged at intervals on the second surface (12) of the substrate (100) along the first direction (Y), each of the plurality of second busbars (22) extending along the second direction (X), wherein each of at least one of the plurality of second busbars (22) adj acent to at least one of the two opposite edges of the substrate (100) extending along the second direction (X) comprises at least one second widened portion (211), and the at least one second widened portion (211) is larger in area than each of the at least one first widened portion (111); and
wherein the solar cell further includes a passivation layer (101) arranged on the first surface (11) of the substrate (100), each respective first widened portion (111) of the at least one first widened portion (111) is abutted on two opposing sides by two respective first fingers (112) of the first fingers (112), a material composition of the respective first widened portion (111) is different from a material composition of each of the two respective first fingers (112), the respective first widened portion (111) is arranged on a surface of the passivation layer (101) away from the substrate without penetrating the passivation layer (101), and the two respective first fingers (112) penetrate through the passivation layer (101) toward the substrate (100), and protrude from the passivation layer (101) in a direction away from the substrate (100) to be higher than the respective first widened portion (111) relative to the first surface (11) of the substrate (100).

2. The solar cell according to claim 1, wherein each of the plurality of first busbars (21) includes two first electrodes (110) adjacent to at least one of the two opposite edges of the substrate (100) extending along the second direction (X) and a plurality of second electrodes (120) arranged between the two first electrodes (110), and each of the two first electrodes (110) includes the at least one first widened portion (111); each of the plurality of second electrodes (120) includes at least one third widened portion (121) arranged opposite to the at least one first widened portion (111) along the first direction (Y), and each of the at least one third widened portion (121) is smaller in area than each of the at least one first widened portion (111).

3. The solar cell according to claim 1 or 2, wherein each of the plurality of second busbars (22) includes a plurality of third electrodes (210) arranged at intervals along the first direction (Y) and a plurality of fourth electrodes (220) arranged between every two third electrodes (210) of the plurality of third electrodes (210), and each of the plurality of third electrodes (210) includes the at least one second widened portion (211); each of the plurality of fourth electrodes (220) includes at least one fourth widened portion (221) arranged opposite to the at least one second widened portion (211) along the first direction (Y), and each of the at least one fourth widened portion (221) is smaller in area than each of the at least one second widened portion (211).

4. The solar cell according to claim 3, wherein each of the at least one fourth widened portion (221) is smaller in area than each of the at least one first widened portion (111).

5. The solar cell according to claim 3, wherein there are 2 to 20 third electrodes (210) on the second surface (12).

6. The solar cell according to claim 1, wherein each of the at least one second widened portion (211) has a width of 0.2mm to 1.0mm along the first direction (Y).

7. The solar cell according to claim 1, wherein each of the plurality of first busbars (21) is integrally formed, and each of the plurality of second busbars (22) is integrally formed.

8. A photovoltaic module, comprising:
at least one cell string, wherein the cell string is formed by electrically connecting a plurality of solar cells (50) with each other by a plurality of welding strips (40), each of the plurality of solar cells (50) is a solar cell according to claim 1 and includes:
a substrate (100) having a first surface (11) and a second surface (12) opposite to the first surface (11);
a plurality of first busbars (21) arranged at intervals on the first surface (11) of the substrate (100) along a first direction (Y), each of the plurality of first busbars (21) extending along a second direction (X), wherein each of at least one of the plurality of first busbars (21) adjacent to at least one of two opposite edges of the substrate (100) extending along the second direction (X) comprises at least one first widened portion (111) and first fingers (112); and
a plurality of second busbars (22) arranged at intervals on the second surface (12) of the substrate (100) along the first direction (Y), each of the plurality of second busbars (22) extending along the second direction (X), wherein each of at least one of the plurality of second busbars (22) adjacent to at least one of the two opposite edges of the substrate (100) extending along the second direction (X) comprises at least one second widened portion (211), and the at least one second widened portion (211) is larger in area than each of the at least one first widened portion (111);
wherein the solar cell further includes a passivation layer (101) arranged on the first surface (11) of the substrate (100), each respective first widened portion (111) of the at least one first widened portion (111) is abutted on two opposing sides by two respective first fingers (112) of the first fingers (112), a material composition of the respective first widened portion (111) is different from a material composition of each of the two respective first fingers (112), the respective first widened portion (111) is arranged on a surface of the passivation layer (101) away from the substrate without penetrating the passivation layer (101), and the two respective first fingers (112) penetrate through the passivation layer (101) toward the substrate (100), and protrude from the passivation layer (101) in a direction away from the substrate (100) to be higher than the respective first widened portion (111) relative to the first surface (11) of the substrate (100); and
wherein each of the plurality of welding strips (40) is electrically connected to a respective first busbar (21) and/or a respective second busbar (22), and any of the plurality of welding strips (40) is in electrical contact with at least one first widened portion (111) or at least one second widened portion (211);
at least one encapsulation layer (51) configured to cover the at least one cell string;
at least one cover plate (52) is configured to cover the at least one encapsulation layer (51).

9. The photovoltaic module according to claim 8, wherein there are M first overlapping regions between each of the plurality of welding strips (40) and the plurality of first busbars (21); there are N adhesive points (102) on the each of the plurality of welding strips (40), each of the N adhesive points (102) is configured to cover a respective first overlapping region of the M first overlapping regions at least including a part of the M first overlapping regions defined on at least one first widened portion (111) overlapped by the each of the plurality of welding strips (40), and N is less than M and greater than or equal to a number of the at least one first widened portion (111) overlapped by the each of the plurality of welding strips (40); the at least one encapsulation layer (51) is arranged to cover the N adhesive points (102).

10. The photovoltaic module according to claim 9, wherein 2 ≤ N ≤ 20.

11. The photovoltaic module according to claim 8, wherein the at least one encapsulation layer (51) is arranged on a surface of each of the plurality of second busbars (22), a part of the plurality of welding strips (40) arranged on the second surface (12) is in direct contact with the at least one encapsulation layer (51), and there is no adhesive point (102) on the second surface (12).

12. A method for preparing the photovoltaic module according to any one of claims 8 to 11, comprising:
providing the plurality of solar cells and the plurality of welding strips;
welding each of the plurality of welding strips and a corresponding solar cell of the plurality of solar cells together to form an alloy layer between each of the plurality of welding strips and each of a plurality of first busbars, and between each of the plurality of welding strips and each of a plurality of second busbars, wherein the plurality of solar cells form at least one cell string by the plurality of welding strips after welding treatment;
providing at least one encapsulation layer and at least one cover plate, wherein the at least one encapsulation layer is configured to cover the at least one cell string, and the at least one cover plate is configured to cover the at least one encapsulation layer;
laminating the at least one cell string, the at least one encapsulation layer, and the at least one cover plate.

13. The method according to claim 12, wherein there are M first overlapping regions between each of the plurality of welding strips and the plurality of first busbars; after the welding treatment, the method further includes: dispensing adhesive on a part of first overlapping regions on each of the plurality of solar cells to form N adhesive points on the first surface of the substrate, wherein each of the N adhesive points is configured to cover a respective first overlapping region of the M first overlapping regions at least including a part of the M first overlapping regions defined on at least one first widened portion overlapped by the each of the plurality of welding strips (40), and N is less than M and greater than or equal to a number of the at least one first widened portion overlapped by the each of the plurality of welding strips (40).

## Patentansprüche

1. Solarzelle, umfassend:
ein Substrat (100), das eine erste Oberfläche (11) und eine zweite Oberfläche (12) gegenüber der ersten Oberfläche (11) aufweist;
eine Vielzahl von ersten Sammelschienen (21), die in Intervallen auf der ersten Oberfläche (11) des Substrats (100) in einer ersten Richtung (Y) angeordnet sind, wobei sich jede der Vielzahl von ersten Sammelschienen (21) in einer zweiten Richtung (X) erstreckt, wobei jede von mindestens einer der Vielzahl von ersten Sammelschienen (21), die an mindestens eine von zwei gegenüberliegenden Kanten des Substrats (100) angrenzend sind, das sich in der zweiten Richtung (X) erstreckt, mindestens einen ersten erweiterten Abschnitt (111) und erste Finger (112) umfasst;
eine Vielzahl von zweiten Sammelschienen (22), in Intervallen auf der zweiten Oberfläche (12) des Substrats (100) in der ersten Richtung (Y) angeordnet sind, wobei sich jede der Vielzahl von zweiten Sammelschienen (22) in der zweiten Richtung (X) erstreckt, wobei jede von mindestens einer der Vielzahl von zweiten Sammelschienen (22), die an mindestens eine der beiden gegenüberliegenden Kanten des Substrats (100) angrenzend sind, das sich in der zweiten Richtung (X) erstreckt, mindestens einen zweiten erweiterten Abschnitt (211) umfasst, und der mindestens eine zweite erweiterte Abschnitt (211) flächenmäßig größer als jeder von dem mindestens einen ersten erweiterten Abschnitt (111) ist; und
wobei die Solarzelle ferner eine Passivierungsschicht (101) umfasst, die auf der ersten Oberfläche (11) des Substrats (100) angeordnet ist, jeder jeweilige erste erweiterte Abschnitt (111) von dem mindestens einen ersten erweiterten Abschnitt (111) auf zwei gegenüberliegenden Seiten durch zwei jeweilige erste Finger (112) der ersten Finger (112) zur Anlage gebracht wird, eine Materialzusammensetzung des jeweiligen ersten erweiterten Abschnitts (111) anders ist als eine Materialzusammensetzung jedes der beiden jeweiligen ersten Finger (112), der jeweilige erste erweiterte Abschnitt (111) auf einer Oberfläche der Passivierungsschicht (101) von dem Substrat entfernt angeordnet ist, ohne in die Passivierungsschicht (101) einzudringen, und die beiden jeweiligen ersten Finger (112) durch die Passivierungsschicht (101) hindurch in Richtung auf das Substrat (100) eindringen, und aus der Passivierungsschicht (101) in einer Richtung von dem Substrat (100) entfernt vorstehen, um im Verhältnis zu der ersten Oberfläche (11) des Substrats (100) höher als der jeweilige erste erweiterte Abschnitt (111) zu sein.

2. Solarzelle nach Anspruch 1, wobei jede der Vielzahl von ersten Sammelschienen (21) zwei erste Elektroden (110), die an mindestens eine der beiden gegenüberliegenden Kanten des Substrats (100) angrenzend sind, das sich in der zweiten Richtung (X) erstreckt, und eine Vielzahl von zweiten Elektroden (120), die zwischen den beiden ersten Elektroden (110) angeordnet sind, umfasst, und jede der beiden ersten Elektroden (110) den mindestens einen ersten erweiterten Abschnitt (111) umfasst; wobei jede der Vielzahl von zweiten Elektroden (120) mindestsens einen dritten erweiterten Abschnitt (121) umfasst, der gegenüber dem mindestsens einen ersten erweiterten Abschnitt (111) in der ersten Richtung (Y) angeordnet ist, und jeder von dem mindestsens einen dritten erweiterten Abschnitt (121) flächenmäßig kleiner als jeder von dem mindestens einen ersten erweiterten Abschnitt (111) ist.

3. Solarzelle nach Anspruch 1 oder 2, wobei jede der Vielzahl von zweiten Sammelschienen (22) eine Vielzahl von dritten Elektroden (210), die in Intervallen in der ersten Richtung (Y) angeordnet sind, und eine Vielzahl von vierten Elektroden (220), die zwischen jeweils zwei dritten Elektroden (210) der Vielzahl von dritten Elektroden (210) angeordnet sind, umfasst, und jede der Vielzahl von dritten Elektroden (210) den mindestens einen zweiten erweiterten Abschnitt (211) umfasst; wobei jede der Vielzahl von vierten Elektroden (220) mindestsens einen vierten erweiterten Abschnitt (221), der gegenüber dem mindestens einen zweiten erweiterten Abschnitt (211) in der ersten Richtung (Y) angeordnet ist, umfasst, und jeder von dem mindestsens einen vierten erweiterten Abschnitt (221) flächenmäßig kleiner als jeder von dem mindestens einen zweiten erweiterten Abschnitt (211) ist.

4. Solarzelle nach Anspruch 3, wobei jeder von dem mindestsens einen vierten erweiterten Abschnitt (221) flächenmäßig kleiner als jeder von dem mindestens einen ersten erweiterten Abschnitt (111) ist.

5. Solarzelle nach Anspruch 3, wobei es 2 bis 20 dritte Elektroden (210) auf der zweiten Oberfläche (12) gibt.

6. Solarzelle nach Anspruch 1, wobei jeder von dem mindestens einen zweiten erweiterten Abschnitt (211) eine Breite von 0,2 mm bis 1,0 mm in der ersten Richtung (Y) aufweist.

7. Solarzelle nach Anspruch 1, wobei jede der Vielzahl von ersten Sammelschienen (21) einstückig gebildet ist, und jede der Vielzahl von zweiten Sammelschienen (22) einstückig gebildet ist.

8. Photovoltaikmodul, umfassend:
mindestsens einen Zellenstrang, wobei der Zellenstrang gebildet wird, indem eine Vielzahl von Solarzellen (50) durch eine Vielzahl von Schweißstreifen (40) elektrisch miteinander verbunden wird, wobei jede der Vielzahl von Solarzellen (50) eine Solarzelle nach Anspruch 1 ist und umfasst:
ein Substrat (100), das eine erste Oberfläche (11) und eine zweite Oberfläche (12) gegenüber der ersten Oberfläche (11) aufweist;
eine Vielzahl von ersten Sammelschienen (21), die in Intervallen auf der ersten Oberfläche (11) des Substrats (100) in einer ersten Richtung (Y) angeordnet sind, wobei sich jede der Vielzahl von ersten Sammelschienen (21) in einer zweiten Richtung (X) erstreckt, wobei jede von mindestens einer der Vielzahl von ersten Sammelschienen (21), die an mindestens eine von zwei gegenüberliegenden Kanten des Substrats (100) angrenzend sind, das sich in der zweiten Richtung (X) erstreckt, mindestens einen ersten erweiterten Abschnitt (111) und erste Finger (112) umfasst; und
eine Vielzahl von zweiten Sammelschienen (22), in Intervallen auf der zweiten Oberfläche (12) des Substrats (100) in der ersten Richtung (Y) angeordnet sind, wobei sich jede der Vielzahl von zweiten Sammelschienen (22) in der zweiten Richtung (X) erstreckt, wobei jede von mindestens einer der Vielzahl von zweiten Sammelschienen (22), die an mindestens eine der beiden gegenüberliegenden Kanten des Substrats (100) angrenzend sind, das sich in der zweiten Richtung (X) erstreckt, mindestens einen zweiten erweiterten Abschnitt (211) umfasst, und der mindestens eine zweite erweiterte Abschnitt (211) flächenmäßig größer als jeder von dem mindestens einen ersten erweiterten Abschnitt (111) ist;
wobei die Solarzelle ferner eine Passivierungsschicht (101) umfasst, die auf der ersten Oberfläche (11) des Substrats (100) angeordnet ist, jeder jeweilige erste erweiterte Abschnitt (111) von dem mindestens einen ersten erweiterten Abschnitt (111) auf zwei gegenüberliegenden Seiten durch zwei jeweilige erste Finger (112) der ersten Finger (112) zur Anlage gebracht wird, eine Materialzusammensetzung des jeweiligen ersten erweiterten Abschnitts (111) anders ist als eine Materialzusammensetzung jedes der beiden jeweiligen ersten Finger (112), der jeweilige erste erweiterte Abschnitt (111) auf einer Oberfläche der Passivierungsschicht (101) von dem Substrat entfernt angeordnet ist, ohne in die Passivierungsschicht (101) einzudringen, und die beiden jeweiligen ersten Finger (112) durch die Passivierungsschicht (101) hindurch in Richtung auf das Substrat (100) eindringen, und aus der Passivierungsschicht (101) in einer Richtung von dem Substrat (100) entfernt vorstehen, um im Verhältnis zu der ersten Oberfläche (11) des Substrats (100) höher als der jeweilige erste erweiterte Abschnitt (111) zu sein; und
wobei jeder der Vielzahl von Schweißstreifen (40) mit einer jeweiligen ersten Sammelschiene (21) und/oder einer jeweiligen zweiten Sammelschiene (22) elektrisch verbunden ist, und einer der Vielzahl von Schweißstreifen (40) mit mindestsens einem ersten erweiterten Abschnitt (111) oder mindestens einem zweiten erweiterten Abschnitt (211) in elektrischem Kontakt steht;
mindestsens eine Verkapselungsschicht (51), die dazu konfiguriert ist, den mindestsens einen Zellenstrang abzudecken;
mindestsens eine Deckplatte (52) ist dazu konfiguriert, die mindestsens eine Verkapselungsschicht (51) abzudecken.

9. Photovoltaikmodul nach Anspruch 8, wobei es M erste überlappende Regionen zwischen jeder der Vielzahl von Schweißstreifen (40) und der Vielzahl von ersten Sammelschienen (21) gibt; wobei es N Klebepunkte (102) auf jedem der Vielzahl von Schweißstreifen (40) gibt, jeder der N Klebepunkte (102) dazu konfiguriert ist, eine jeweilige erste überlappende Region der M ersten überlappenden Regionen abzudecken, die mindestsens einen Teil der M ersten überlappenden Regionen umfassen, die auf mindestsens einem ersten erweiterten Abschnitt (111) definiert sind, der sich mit jedem der Vielzahl von Schweißstreifen (40) überlappt, und N kleiner als M und größer oder gleich einer Anzahl des mindestens einen ersten erweiterten Abschnitts (111) ist, der sich mit jedem der Vielzahl von Schweißstreifen (40) überlappt; wobei die mindestsens eine Verkapselungsschicht (51) dazu angeordnet ist, N Klebepunkte (102) abzudecken.

10. Photovoltaikmodul nach Anspruch 9, wobei 2 ≤ N ≤ 20.

11. Photovoltaikmodul nach Anspruch 8, wobei die mindestsens eine Verkapselungsschicht (51) auf einer Oberfläche jeder der Vielzahl von zweiten Sammelschienen (22) angeordnet ist, ein Teil der Vielzahl von Schweißstreifen (40), der auf der zweiten Oberfläche (12) angeordnet ist, in direktem Kontakt mit der mindestsens einen Verkapselungsschicht (51) steht, und es keinen Klebepunkt (102) auf der zweiten Oberfläche (12) gibt.

12. Verfahren zum Anfertigen des Photovoltaikmoduls nach einem der Ansprüche 8 bis 11, umfassend:
Bereitstellen der Vielzahl von Solarzellen und der Vielzahl von Schweißstreifen;
Zusammenschweißen jedes der Vielzahl von Schweißstreifen und einer entsprechenden Solarzelle der Vielzahl von Solarzellen, um zwischen jedem der Vielzahl von Schweißstreifen und jeder einer Vielzahl von ersten Sammelschienen und zwischen jedem der Vielzahl von Schweißstreifen und jeder einer Vielzahl von zweiten Sammelschienen eine Legierungsschicht zu bilden, wobei die Vielzahl von Solarzellen mindestsens einen Zellenstrang durch die Vielzahl von Schweißstreifen nach der Schweißbehandlung bildet;
Bereitstellen mindestsens einer Verkapselungsschicht und mindestsens einer Deckplatte, wobei die mindestsens eine Verkapselungsschicht dazu konfiguriert ist, den mindestsens einen Zellenstrang abzudecken, und die mindestsens eine Deckplatte dazu konfiguriert ist, die mindestsens eine Verkapselungsschicht abzudecken;
Laminieren des mindestsens einen Zellenstrangs, der mindestsens einen Verkapselungsschicht und der mindestsens einen Deckplatte.

13. Verfahren nach Anspruch 12, wobei es M erste überlappende Regionen zwischen jedem der Vielzahl von Schweißstreifen und der Vielzahl von ersten Sammelschienen gibt; wobei das Verfahren nach der Schweißbehandlung ferner umfasst: Abgeben von Klebstoff auf einem Teil der ersten überlappenden Regionen auf jeder der Vielzahl von Solarzellen, um N Klebepunkte auf der ersten Oberfläche des Substrats zu bilden, wobei jeder der N Klebepunkte dazu konfiguriert ist, eine jeweilige erste überlappende Region der M ersten überlappenden Regionen abzudecken, die mindestens einen Teil der M ersten überlappenden Regionen umfassen, die auf mindestens einem ersten erweiterten Abschnitt definiert sind, der sich mit jedem der Vielzahl von Schweißstreifen (40) überlappt, und N kleiner als M und größer oder gleich einer Anzahl des mindestens einen ersten erweiterten Abschnitts ist, der sich mit jedem der Vielzahl von Schweißstreifen (40) überlappt.

## Revendications

1. Cellule solaire comprenant :
un substrat (100) ayant une première surface (11) et une seconde surface (12) opposée à la première surface (11) ;
une pluralité de premières barres omnibus (21) agencées à intervalles sur la première surface (11) du substrat (100) le long d'une première direction (Y), chacune de la pluralité de premières barres omnibus (21) s'étendant le long d'une seconde direction (X), dans laquelle chacune d'au moins l'une de la pluralité de premières barres omnibus (21) adjacente à au moins l'un des deux bords opposés du substrat (100) s'étendant le long de la seconde direction (X) comprenant au moins une première partie élargie (111) et des premiers doigts (112) ; et
une pluralité de secondes barres omnibus (22) agencées à intervalles sur la seconde surface (12) du substrat (100) le long de la première direction (Y), chacune de la pluralité de secondes barres omnibus (22) s'étendant dans la seconde direction (X), dans laquelle chacune d'au moins l'une de la pluralité de secondes barres omnibus (22) adjacente à au moins l'un des deux bords opposés du substrat (100) s'étendant le long de la seconde direction (X) comprend au moins une deuxième partie élargie (211), et la au moins une deuxième partie élargie (211) est plus grande du point de vue de la surface que chacune de la au moins une première partie élargie (111) ; et
dans laquelle la cellule solaire comprend en outre une couche de passivation (101) agencée sur la première surface (11) du substrat (100), chaque première partie élargie (111) respective de la au moins une première partie élargie (111) vient en butée sur deux côtés opposés par deux premiers doigts (112) respectifs des premiers doigts (112), une composition de matériau de la première partie élargie (111) respective est différente d'une composition de matériau de chacun des deux premiers doigts (112) respectifs, la première partie élargie (111) respective est agencée sur une surface de la couche de passivation (101) à l'opposé du substrat sans pénétrer dans la couche de passivation (101) et les deux premiers doigts (112) respectifs pénètrent à travers la couche de passivation (101) vers le substrat (100) et font saillie de la couche de passivation (101) dans une direction à l'opposé du substrat (100) pour être plus hauts que la première partie élargie (111) respective par rapport à la première surface (11) du substrat (100).

2. Cellule solaire selon la revendication 1, dans laquelle chacune de la pluralité de premières barres omnibus (21) comprend deux premières électrodes (110) adjacentes à au moins l'un des deux bords opposés du substrat (100) s'étendant le long de la seconde direction (X) et une pluralité de deuxièmes électrodes (120) agencée entre les deux premières électrodes (110), et chacune des deux premières électrodes (110) comprend la au moins une première partie élargie (111) ; chacune de la pluralité de deuxièmes électrodes (120) comprend au moins une troisième partie élargie (121) agencée à l'opposé de la au moins une première partie élargie (111) le long de la première direction (Y), et chacune de la au moins une troisième partie élargie (121) est inférieure, du point de vue de la surface, à chacune de la au moins une première partie élargie (111).

3. Cellule solaire selon la revendication 1 ou 2, dans laquelle chacune de la pluralité de secondes barres omnibus (22) comprend une pluralité de troisièmes électrodes (210) agencées à intervalles le long de la première direction (Y) et une pluralité de quatrièmes électrodes (220) agencées toutes les deux troisièmes électrodes (210) de la pluralité de troisièmes électrodes (210) et chacune de la pluralité de troisièmes électrodes (210) comprend la au moins une deuxième partie élargie (211) ; chacune de la pluralité de quatrièmes électrodes (220) comprend au moins une quatrième partie élargie (221) agencée à l'opposé de la au moins une deuxième partie élargie (211) le long de la première direction (Y) et chacune de la au moins une quatrième partie élargie (221) est inférieure, du point de vue de la surface, à chacune de la au moins une deuxième partie élargie (211).

4. Cellule solaire selon la revendication 3, dans laquelle chacune de la au moins une quatrième partie élargie (221) est inférieure, du point de vue de la surface, à chacune de la au moins une première partie élargie (111).

5. Cellule solaire selon la revendication 3, dans laquelle on trouve de 2 à 20 troisièmes électrodes (210) sur la seconde surface (12).

6. Cellule solaire selon la revendication 1, dans laquelle chacune de la au moins une deuxième partie élargie (211) a une largeur de 0,2 mm à 1,0 mm le long de la première direction (Y).

7. Cellule solaire selon la revendication 1, dans laquelle chacune de la pluralité de premières barres omnibus (21) est formée, de manière solidaire, et chacune de la pluralité de secondes barres omnibus (22) est formée, de manière solidaire.

8. Module photovoltaïque comprenant :
au moins une chaîne de cellules, dans lequel la chaîne de cellules est formée en raccordant électriquement une pluralité de cellules solaires (50) entre elles par une pluralité de bandes de soudure (40), chacune de la pluralité de cellules solaires (50) est une cellule solaire selon la revendication 1, et comprend :
un substrat (100) ayant une première surface (11) et une seconde surface (12) opposée à la première surface (11) ;
une pluralité de premières barres omnibus (21) agencées à intervalles sur la première surface (11) du substrat (100) le long d'une première direction (Y), chacune de la pluralité de premières barres omnibus (21) s'étendant le long d'une seconde direction (X), dans laquelle chacune d'au moins l'une de la pluralité de premières barres omnibus (21) adjacente à au moins l'un des deux bords opposés du substrat (100) s'étendant le long de la seconde direction (X) comprenant au moins une première partie élargie (111) et des premiers doigts (112) ; et
une pluralité de secondes barres omnibus (22) agencées à intervalles sur la seconde surface (12) du substrat (100) le long de la première direction (Y), chacune de la pluralité de secondes barres omnibus (22) s'étendant dans la seconde direction (X), dans laquelle chacune d'au moins l'une de la pluralité de secondes barres omnibus (22) adjacente à au moins l'un des deux bords opposés du substrat (100) s'étendant le long de la seconde direction (X) comprend au moins une deuxième partie élargie (211), et la au moins une deuxième partie élargie (211) est plus grande du point de vue de la surface que chacune de la au moins une première partie élargie (111) ;
dans lequel la cellule solaire comprend en outre une couche de passivation (101) agencée sur la première surface (11) du substrat (100), chaque première partie élargie (111) respective de la au moins une première partie élargie (111) vient en butée sur deux côtés opposés par deux premiers doigts (112) respectifs des premiers doigts (112), une composition de matériau de la première partie élargie (111) respective est différente d'une composition de matériau de chacun des deux premiers doigts (112) respectifs, la première partie élargie (111) respective est agencée sur une surface de la couche de passivation (101) à l'opposé du substrat sans pénétrer dans la couche de passivation (101) et les deux premiers doigts (112) respectifs pénètrent à travers la couche de passivation (101) vers le substrat (100) et font saillie de la couche de passivation (101) dans une direction à l'opposé du substrat (100) pour être plus hauts que la première partie élargie (111) respective par rapport à la première surface (11) du substrat (100) ; et
dans lequel chacune de la pluralité de bandes de soudure (40) est électriquement raccordée à une première barre omnibus (21) respective et/ou une seconde barre omnibus (22) respective, et l'une quelconque de la pluralité de bandes de soudure (40) est en contact électrique avec au moins une première partie élargie (111) ou au moins la deuxième partie élargie (211) ;
au moins une couche d'encapsulation (51) configurée pour recouvrir la au moins une chaîne de cellules ;
au moins une plaque de couvercle (52) est configurée pour recouvrir la au moins une couche d'encapsulation (51).

9. Module photovoltaïque selon la revendication 8, dans lequel il y a M premières régions chevauchantes entre chacune de la pluralité de bandes de soudure (40) et la pluralité de premières barres omnibus (21) ; il y a N points adhésifs (102) sur chacune de la pluralité de bandes de soudure (40), chacun des N points adhésifs (102) est configuré pour recouvrir une première région chevauchante respective des M premières régions chevauchantes comprenant au moins une partie des M premières régions chevauchantes définies sur au moins une première partie élargie (111) chevauchée par chacune de la pluralité de bandes de soudure (40) et N est inférieur à M et supérieur ou égal à un nombre de la au moins une première partie élargie (111) chevauchée par chacune de la pluralité de bandes de soudure (40) ; la au moins une couche d'encapsulation (51) est agencée pour recouvrir les N points adhésifs (102).

10. Module photovoltaïque selon la revendication 9, dans lequel 2 ≤ N ≤ 20.

11. Module photovoltaïque selon la revendication 8, dans lequel la au moins une couche d'encapsulation (51) est agencée sur une surface de chacune de la pluralité de secondes barres omnibus (22), une partie de la pluralité de bandes de soudure (40) agencée sur la seconde surface (12) est en contact direct avec la au moins une couche d'encapsulation (51), et il n'y a pas de point adhésif (102) sur la seconde surface (12).

12. Procédé pour préparer le module photovoltaïque selon l'une quelconque des revendications 8 à 11, comprenant les étapes consistant à :
prévoir la pluralité de cellules solaires et la pluralité de bandes de soudure ;
souder chacune de la pluralité de bandes de soudure et une cellule solaire correspondante de la pluralité de cellules solaires ensemble afin de former une couche d'alliage entre chacune de la pluralité de bandes de soudure et chacune d'une pluralité de premières barres omnibus, et entre chacune de la pluralité de bandes de soudure et chacune d'une pluralité de secondes barres omnibus, dans lequel la pluralité de cellules solaires forme au moins une chaîne de cellules par la pluralité de bandes de soudure après traitement de soudure ;
prévoir au moins une couche d'encapsulation et au moins une plaque de couvercle, dans lequel la au moins une couche d'encapsulation est configurée pour recouvrir la au moins une chaîne de cellules, et la au moins une plaque de couvercle est configurée pour recouvrir la au moins une couche d'encapsulation ;
stratifier la au moins une chaîne de cellules, la au moins une couche d'encapsulation et la au moins une plaque de couvercle.

13. Procédé selon la revendication 12, dans lequel il y a M premières régions chevauchantes entre chacune de la pluralité de bandes de soudure et la pluralité de premières barres omnibus ; après le traitement de soudure, le procédé comprenant en outre l'étape consistant à : distribuer l'adhésif sur une partie des premières régions chevauchantes sur chacune de la pluralité de cellules solaires afin de former N points adhésifs sur la première surface du substrat, dans lequel chacun des N points adhésifs est configuré pour recouvrir une première région chevauchante respective des M premières régions chevauchantes comprenant au moins une partie des M premières régions chevauchantes définies sur au moins une première partie élargie chevauchée par chacune de la pluralité de bandes de soudure (40), et N est inférieur à M et supérieur ou égal à un nombre de la au moins une première partie élargie chevauchée par chacune de la pluralité de bandes de soudure (40).
